# EUROPEAN PATENT SPECIFICATION

(11) **EP 1 299 922 B1**
(45) Date of publication and mention of the grant of the patent: **08.10.2008**
(21) Application number: 01959822.6
(22) Date of filing: 26.07.2001
(51) Int. Cl.: H03G 3/30, G01R 21/10

(54) **SUCCESSIVE LOG VIDEO PAD POWER DETECTOR AND METHOD**
SUKZESSIVER LOG-VIDEOANSCHLUSS, LEISTUNGSDETEKTOR UND VERFAHREN
PROCEDE ET DETECTEUR DE PUISSANCE DE TAMPONS A LOG-VIDEO SUCCESSIFS

(30) Priority: 28.07.2000 US 221516 P; 28.06.2001 US 893009
(43) Date of publication of application: 09.04.2003
(73) Proprietor: HARRIS CORPORATION, Melbourne, FL 32919 (US)
(72) Inventor: JOHNSON, Kent, K., South Lake Tahoe, CA 96156 (US)
(74) Representative: Schmidt, Steffen J.
(86) International application number: PCT/US2001/041405
(87) International publication number: WO 2002/011349

(56) References cited:
- EP-A- 0 320 265
- WO-A-99/67893
- GB-A- 2 350 955
- US-A- 3 435 353
- US-A- 4 873 484
- US-A- 5 126 686
- US-A- 5 854 971
- US-A- 5 918 166
- US-B1- 6 229 375
- PATENT ABSTRACTS OF JAPAN vol. 1999, no. 10, 31 August 1999 (1999-08-31) & JP 11 127084 A (MITSUBISHI ELECTRIC CORP), 11 May 1999 (1999-05-11)
- "A Universal Power Sensor" MICROWAVE JOURNAL, vol. 43, no. 3, March 2000 (2000-03), pages 130-134, XP001206951 USA

## Description

### BACKGROUND OF INVENTION

Applicant's disclosure is directed to an improved method and system for controlling the transmit power level in a communication device. Specifically, applicant's disclosure is directed to a power detector having an improved dynamic power range that is less complex and cheaper to construct than conventional power detectors having a similar power range:

The use of signal amplifiers in radio communications is well known. For hand held communication devices, federal regulations, collision avoidance and battery power conservation are factors which dictate tight control over the transmitted power level of the RF signals, the goal being to transmit at sufficient power to ensure reliable reception of the transmitted signal while avoiding unnecessary drain on battery resources and avoiding signal collision with other communication devices.

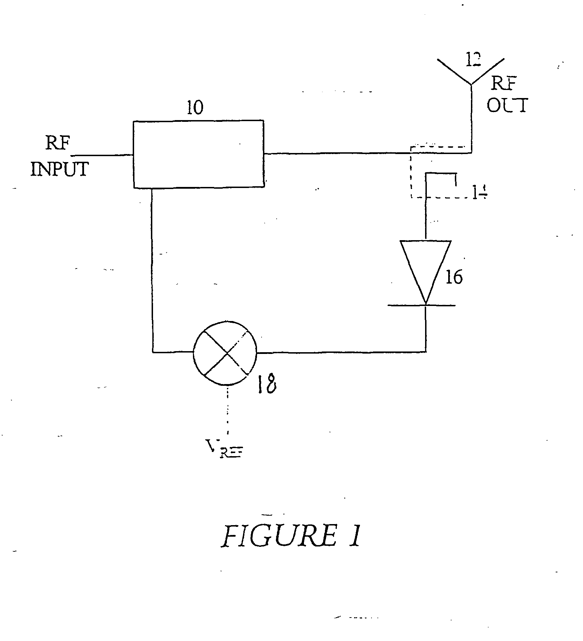

A conventional method for determining transmit signal power level is to use a simple single stage diode envelope detector. Figure 1 is a simplified diagram of one such prior art power detector. An RF input signal is received by the power control circuit 10 where the signal is amplified or attenuated as necessary and then sent to antenna 12 where the RF output signal is transmitted. Prior to transmission, the RF output signal is sampled by a coupler 14. The coupler 14 provides the sampled signal to the diode detector 16. Detector 16 generates a signal (normally DC volts) which is proportional to the output power of the RF suit signal. The detector signal is then compared at comparator 18 against a reference signal which corresponds to the desired output power level of the transmitter. The output of the comparator 18 drives the amplification/attenuator network 10 which either increases or decreases the power level as necessary to control the transmit power level.

The single diode detector is simple and cheap method of power control in communication devices. However, there are several limitations to the diode detector which may effect product performance and add costs to the power detector.

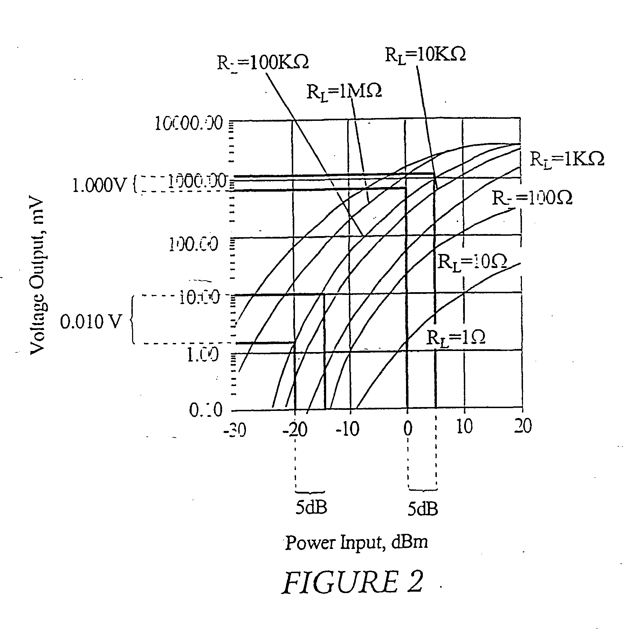

The simple diode detector has a narrow practical operating power range. The nonlinear response of the diode detector is a square law function, not a log-linear detector. Though a square law curve is not a bad approximation for a log-linear curve over a small operating range, wide dynamic ranges present the need for a level dependent correction factor. For example and with Reference to Figure 2, at high powers 1.000 volt might represent a 5 dB change in power, where at low powers 0.010 volts might represent the same 5 dB change in power.

Thus, for the lower signal levels sensitivities of 2 mV/dB are not uncommon. To maintain a 10 dB signal to noise ratio the noise floor must be below 2001mV -- a level difficult to achieve in a noisy environment.

Additionally, a 10 to 15 dB dynamic range is all that is useable, because the detector's non-linear response rapidly drops the detected output voltage for low power input signals making noise immunity an issue.

Another important concern is that the repeatability of the signal diode detector curve is not very good, which is critical if multiple diodes are used together. The curves are a strong function of the doping gradients in the semiconductor, the load presented to the diode and the temperature of operation. It is possible to control the load fairly consistently, however the doping gradients vary as a function of many processing steps, which are difficult to control. Even if diodes were matched and loads were controlled carefully, the curves vary significantly with temperature.

Changes in ambient temperature in the environment of the diode can significantly change the output of the diode. The temperature effect on a diode detector are quite pronounced and attributable primarily to changes in the forward barrier and video resistance. Unfortunately, neither property is easily controlled and thus it is usually necessary to use some sort of temperature compensation circuit to remove the effects of temperature from the output of the diode detector.

In summary a single diode detector only has a narrow power range where repeatable, stable, good signal to noise measurements can be made. For wide dynamic ranges (40 dB) another solution must be sought.

The Successive Log Video Amplifier (SLVA) concept has been around for many years and provides an accurate log-linear response over very wide dynamic ranges. The SLVA utilizes a series of diode detectors, with each detector operating in a narrow power range. The detectors only receive a portion of the sampled signal and the output of the detectors must be summed to provide an accurate representation of the transmit signal level. The use of a series of diode detectors requires that the sampled signal be divided among the detector. The SLVA uses a amplifier cascade to provide portions of the sampled signal to the detectors.

The SLVA is built from a successive cascade of very carefully gain-matched amplifiers. Between each amplifier a simple diode detector is placed. Each amplifier typically has a gain of about 10 dB. Thus, the diode detectors only need to detect power over the range where the detector is well behaved and has good noise immunity.
The outputs of the detectors are then summed together in such a way to produce a close approximation to a log-linear response. SLVA's are commonly available with ten plus stages with accuracy being better than 1 dB over a 100 dB dynamic range.

With the exception of a few monolithic designs, SLVA's are however typically very expensive. The reason for the high cost is the need for very accurate gain matching. This matching requires high skilled labor and significant tuning time. Higher frequency applications require closer matching thus increasing the costs even further. For example, at microwave frequencies, each stage must be gain matched to often better than 1 dB.

Thus, the concept of using a series of amplifiers with detectors operating over a narrow range and summing the detectors works well for low power signals and thus the SLVA is almost always used for detecting very low power signal levels. This device is commonly used in both radar systems and spectrum analyzers and recently this technology has been applied via a monolithic device from Analog Devices. However, such monolithic devices are not available above 3GHz or above + 10dB and although not as expensive as traditional gain matched amplifier cascade, monolithic devices still require significant development costs.

Recently communication devices operating in the very high frequency (VHF) spectrum have been made available for commercial use, e.g. milimeter wave systems. Such high frequency systems are susceptible to significant signal degradation due to atmospheric conditions. For examples, very high frequency signals suffer significant attenuation during rain storms. One method of mitigating this rain attenuation effect is to increase the power level of the transmitted signal in order to "burn" through the signal to the receiving station. When the rain attenuation effect is not present the power level of the transmitted signal can be reduced and thus battery power of the communication device is conserved. Thus, there is a need for a power detector which works over a broad power range, i.e. both high and low power, without the attendant costs and time associated with matched gain filters.

US-B-4,873,484 discloses a probe for sensing radio frequency power. The probe comprises two diodes which are independently driven through a common RF input, through a branch network which separates and feeds the probe RF power to each diode. Thus, one diode operates in a lower dBm range, while the other diode operates in a higher dBm range.

Patent abstracts of Japan JP 11 127 084 describes a summer which is responsive to output signals from two diode detectors for producing a control signal, as well as a control unit for adjusting the transmit power level in response to the control signal.

An amplifier-detector having a wide dynamic range is disclosed in US-B-3,435,353. The amplifier-detector comprises a cascade of several linear amplifiers which are connected to linear detectors. The output of each detector is connected to a wave shaping circuit, the output of which is a logarithmic function of its input over a certain amplitude range. Below this range, the output of the wave shaping network is negligible, and above this range the output remains substantially constant.

A universal power sensor is described in "A Universal Power Sensor" published in Microwave Journal, Vol. 43, No. 3, March 2000, pages 130-134. The power sensor has a conventional diode sensor's fast response time and low power sensitivity as well as a wider dynamic range for true RMS detecting. The power sensor increases the overall sensor dynamic range by combining three separate diode detection elements into a single sensor.

Accordingly, it s an object of the present invention to provide a novel power detector which has a dynamic power range and works at both high and low power.

It is another object of the present invention to provide a novel power detector which can be used at high frequency without the attendant time and costs associated with gain matched filters.

It is yet another objective of the present invention to provide a novel power detector which utilizes low cost reliable diode detectors without an associated amplifier cascade.

It is still another object of the present invention to provide a novel power detector for use with high frequencies at high and low powers without the use of cascaded active elements.

It is yet still another object of the present invention to provide a novel power detector which reduces the costs and time required to manufacture.

It is still another object of the present invention to provide a novel method of generating a power control signal proportional to the transmit power level for high and low power applications.

These and many other objects and advantages of the present invention will be readily apparent to one skilled in the art to which the invention pertains from a perusal of the claims, the appended drawings, and the following detailed description of the preferred embodiments.

### BRIEF DESCRIPTION OF THE DRAWINGS

Figure 1 is a simplified block diagram of a single diode detector.
Figure 2 is a typical operating curve for the single diode detector of Figure 1.
Figure 3 is a simplified block diagram of the Successive Log Video Pad (SLVP) power detector utilized by the present invention.

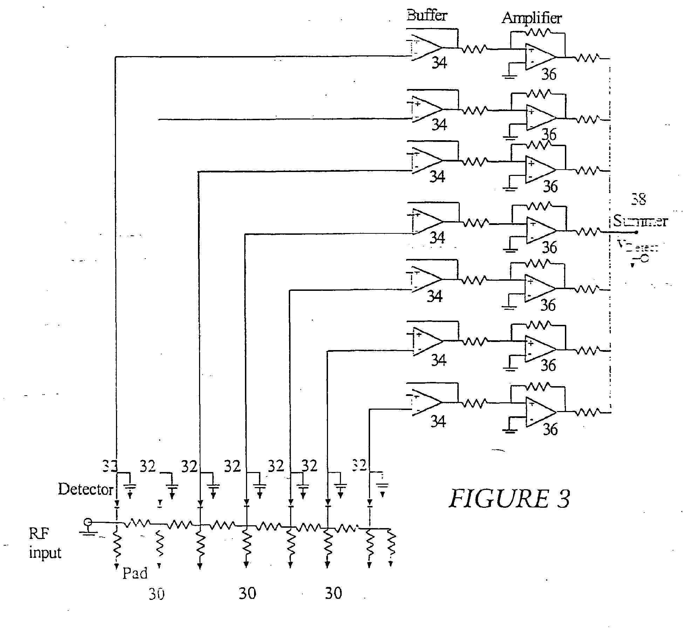

Figure 3 represents one embodiment of applicant's disclosure. The design consists of five main building blocks, the pie pads 30, diode detectors 32, high impedance buffers 34, saturating gain amplifiers 36 and a summer 38.

### THE DETAILED DESCRIPTION

A seven stage detector requires a little more than 5 dB dynamic range from each detector stage. It also fits with in the bounds of 4 quad opamp devices (leaving some spare capability for temperature compensation). Such detectors are stable over the entire 5dB range providing good signal to noise measurements. The detectors may be high sensitivity Zero Bias Diode (ZBD), mounted on top of the integrating capacitor. Bias may not be applied for simplicity and thus the detector stage can be very cheap and accurate.

The pad (attenuator) elements 30 may be discrete pie pads of 5 dB, each bonded to the inside of a carrier module. The pads 30 may be a monolithic thin film part and thus would have the ratio-metric properties of the mask. The shunt ground connection on the pad may be achieved via a wide trace and wire bond and assists in increasing the bandwidth of the device. The passive nature of the RF cascade in the present embodiment is unconditionally stable as compared with the active nature of the amplifier cascade in the prior art SLVA. Additionally, a thin film pad is much smaller than the equivalent gain delta amplifier.

With respect to practical limitations, the realizable gain delta in applicant's disclosure can be very small relative to the practical gain delta of a prior art video amplifier. For example, a 2dB pad cascade is easily realized with thin film technology for pennies, but a 2dB amplifier cascade, though do-able, is very impractical. Amplifier gain blocks tend to come in 8 to 14dB steps, making additional padding necessary to achieve small sizes. Thus, the very fine, ultra log-linear 2 dB steps are expensive to realize with amplifiers.

The ratio-metric precision of a thin film, thick film or semiconductor resistor mask can produce near perfect log-linear responses. This near identical gain delta between detectors-along the pad cascade gives applicant's disclosure excellent performance without the need for adjustment and without the need for gain matched amplifiers that have limited bandwidth and power capability.

The broad band nature of the attenuators of applicant's disclosure provide unusually wide bandwidth capability. Currently prior art devices are available up to 3 GHz with ± 1 dB non-tunable accuracy at low power. Applicant's disclosure is easily fabricated with standard thin film techniques to work at 40 GHz with the same non-tuneable accuracy. The use of cascaded passive elements allows for use with a much broader frequency spectrum and the present embodiment works down to DC which conventional SLVA's can not do.

A buffer 34 may be placed after the detector to insure high DC input impedance. This reduces the effect of the diode video resistance and improves sensitivity.

A high gain operational amplifier (opamp) (Aᵥ= 400) 36 may be used to provide gain and the limiting function necessary for equal gain log-linear summing. Opamps provide low input offset drift and saturation characteristics. Unlike the SLVA's which use the saturation of the video amplifier, the present embodiment uses the saturation of op-amp 36 to limit the contribution of each stage.

The independent nature of each high gain opamp 36 allows superposition to be used for summing, yielding a simple resistive summer 38. Unlike the traditional SLVA, the present embodiment uses purely passive summing of the detector 32 outputs. Because of the opamp saturation requirement to provide the truncation of the detector range, the opamp 36 is configured for high gain and high isolation. This allows for simple superposition of the op-amps' output sources to do the summing.

The opamps 36 may be procured on a single monolithic substrate. The saturation of the opamps 36 is more predictable, abrupt and controllable than the RF saturation characteristics of the video amplifiers typically used in the SLVA.

Typical log-linear errors for the present embodiment at 25 °C are less than 1.0 dB over all but the extremes of the power range. A thermistor compensation circuit (not shown) could implement simple temperature linear correction using the two unused opamps.

In another embodiment of the applicant's disclosure, a single amplifier added before the attenuator cascade allows for the accurate and cheap power detection at low powers. Because applicant's disclosure can deliver excellent log-liner response over a 40dB range without tuning, it is less expensive to add a single gain stage before the cascaded pads to extend the detection range lower than to utilize a gained matched video amplifier cascade as taught in the prior art.

Thus applicant's disclosure provides an easier, less costly, faster, broader band way to make a precision matched, temperature stable attenuator cascade for use to detect transmit power levels in high and low frequency and high and low power applications than taught in the prior art.

While preferred embodiments of the present invention have been described, it is to be understood that the embodiments described are illustrative only and the scope of the invention is to be defined solely by the appended claims when accorded a full range of equivalence, many variations and modifications naturally occurring to those skilled in the art from a perusal hereof

## Claims

1. A power detector for controlling the transmit power level of a communications device comprising:
plural cascaded attenuators (30) for receiving a signal representative of the transmit power level of a communication device and for providing plural attenuator output signals;
plural diode detectors (32) each receiving one of the plural attenuator output signals to thereby provide plural detected signals; and He
a summer (38) responsive to the plural detected signals for producing a control signal having a voltage proportional to the transmit power level of the communications device;
**characterised by**
a control unit for adjusting the transmit power level responsively to the control signal, and
a plurality of high gain operational amplifiers (36), each connected between one of the plural diode detectors (32) and the summer (38).

2. The power detector of Claim 1 wherein said plural attenuators (30) comprise a printed thin film successive pad cascade.

3. The power detector of Claim 1 or 2 wherein said plural attenuators (30) each have substantially the same ratio-metric properties.

4. The power detector of any one of Claims 1 to 3, further comprising plural buffers (34) connected one each between one of said plural detectors (32) and said plurality of high gain operational amplifiers (36) to thereby increase the d.c. input impedance and improve the sensitivity of the power detector.

5. The power detector of any one of Claims 1 to 4 wherein said plural operational amplifiers (36) include portions of a common monolithic substrate.

6. The power detector of any one of Claims 1 to 5, further comprising an amplifier for the signal representative of the transmit power level upstream of said plural attenuators.

7. A power level control circuit for a communications device comprising:
a communications device having a transmitted power level control;
a power detector as claimed in any one of claims 1 to 6 for providing a power level signal representative of the transmit power level of said communication device.

8. A method of controlling the transmit power level of a communication device comprising the steps of:
a. providing a power level signal representative of the power level of the signal transmitted by the communication device;
b. attenuating the power level signal with a successive cascade of attenuators (30) to thereby provide a plurality of attenuator signals;
c. detecting a characteristic of each of the plurality of attenuator signals to thereby provide plural detector signals;
d. amplifying each of the detector signals;
e. summing the amplified detector signals to provide a control signal; and
f. controlling the transmit power level of the communications device responsively to the control signal.

## Patentansprüche

1. Leistungsdetektor zum Steuern des Übertragungsleistungspegels einer Kommunikationseinrichtung, folgendes aufweisend:
eine Mehrzahl von Abschwächern (30) in Kaskadenanordnung zum Empfangen eines Signals, welches den Übertragungsleistungspegel einer Kommunikationseinrichtung wiedergibt und zum Bereitstellen von mehreren Abschwächer-Ausgangssignalen;
mehrere Dioden-Detektoren (32), von denen jeweils einer eines der mehreren Abschwächer-Ausgangssignale empfängt, um so mehrere detektierte Signale bereitzustellen; und
einen Addierer (38), der auf die mehreren detektierten Signale anspricht, um ein Steuersignal zu erzeugen mit einer Spannung, die proportional ist zum Übertragungsleistungspegel der Kommunikationseinrichtung,
**gekennzeichnet durch**
eine Steuereinheit zum Einstellen des Übertragungsleistungspegels entsprechend dem Steuersignal; und
eine Mehrzahl von Operationsverstärkern (36) mit hoher Verstärkung, die jeweils zwischen einem aus der Mehrzahl von Dioden-Detektoren (32) und dem Addierer (38) geschaltet sind.

2. Leistungsdetektor gemäß Anspruch 1, wobei die genannten mehreren Abschwächer (30) eine gedruckte Dünnschichtschaltung aufweisen mit einer sukzessiven Kaskadenanordnung.

3. Leistungsdetektor gemäß einem der Ansprüche 1 oder 2, wobei die genannten mehreren Abschwächer (30) jeweils die gleichen Dimensionsverhältnisse aufweisen.

4. Leistungsdetektor gemäß einem der Ansprüche 1 bis 3, mit weiterhin einer Mehrzahl von Puffern (34), die jeweils zwischen einem aus der Mehrzahl von Detektoren (32) und den genannten Operationsverstärkern (36) mit hohem Verstärkungsfaktor geschaltet sind, um so die Gleichstrom-Eingangsimpedanz zu erhöhen und die Messempfindlichkeit des Leistungsdetektors zu verbessern.

5. Leistungsdetektor gemäß einem der Ansprüche 1 bis 4, wobei die genannte Mehrzahl von Operationsverstärkern (36) Abschnitte eines gemeinsamen monolithischen Substrates umfasst.

6. Leistungsdetektor gemäß einem der Ansprüche 1 bis 5, weiterhin aufweisend einen Verstärker für das Signal, welches den Übertragungsleistungspegel darstellt, stromauf der genannten Mehrzahl von Abschwächern.

7. Leistungspegelsteuerschaltung für eine Kommunikationseinrichtung, folgendes aufweisend:
einen Kommunikationseinrichtung mit einer Steuerung für den Übertragungsleistungspegel;
einem Leistungsdetektor gemäß einem der Ansprüche 1 bis 6 zur Bereitstellung eines Leistungspegelsignals, welches dem Übertragungsleistungspegel der Kommunikationseinrichtung entspricht.

8. Verfahren zum Steuern des Übertragungsleistungspegels einer Kommunikationseinrichtung mit folgenden Schritten:
a. Bereitstellen eines Leistungspegelsignals entsprechend dem Leistungspegel des von der Kommunikationseinrichtung übertragenen Signals;
b. Abschwächen des Leistungspegelsignals mit einer sukzessiven Kaskade von Abschwächern (30), um so eine Mehrzahl von Abschwächersignalen bereitzustellen;
c. Detektieren einer Eigenschaft von jedem der mehreren Abschwächersignale, um so eine Mehrzahl von Detektorsignalen bereitzustellen;
d. Verstärken von jedem der Detektorsignale;
e. Addieren der verstärkten Detektorsignale, um ein Steuersignal zu erhalten; und
f. Steuern des Übertragungsleistungspegels der Kommunikationseinrichtung entsprechend dem Steuersignal.

## Revendications

1. Détecteur de puissance pour commander le niveau de puissance de transmission d'un dispositif de communications comprenant :
des atténuateurs multiples en cascade (30) pour recevoir un signal représentatif du niveau de puissance de transmission d'un dispositif de communication et pour délivrer des signaux de sortie d'atténuateurs multiples ;
des détecteurs à diode multiples (32) recevant chacun l'un des signaux de sortie d'atténuateurs multiples pour ainsi délivrer des signaux détectés multiples ; et
un sommateur (38) répondant aux signaux détectés multiples pour produire un signal de commande ayant une tension proportionnelle au niveau de puissance de transmission du dispositif de communications ;
**caractérisé par**
une unité de commande pour ajuster le niveau de puissance de transmission en réponse au signal de commande, et
une pluralité d'amplificateurs opérationnels à gain élevé (36), chacun connecté entre l'un des détecteurs à diode multiples (32) et le sommateur (38).

2. Détecteur de puissance selon la revendication 1, dans lequel lesdits atténuateurs multiples (30) comprennent une cascade d'atténuateurs successifs en film mince imprimé.

3. Détecteur de puissance selon la revendication 1 ou 2, dans lequel lesdits atténuateurs multiples (30) ont chacun substantiellement les mêmes propriétés radiométriques.

4. Détecteur de puissance selon l'une quelconque des revendications 1 à 3, comprenant en outre des tampons multiples (34) connectés chacun entre l'un desdits détecteurs multiples (32) et ladite pluralité d'amplificateurs opérationnels à gain élevé (36) pour ainsi augmenter l'impédance d'entrée de c.c. et améliorer la sensibilité du détecteur de puissance.

5. Détecteur de puissance selon l'une quelconque des revendications 1 à 4, dans lesquels lesdits amplificateurs opérationnels multiples (36) incluent des portions d'un substrat monolithique commun.

6. Détecteur de puissance selon l'une quelconque des revendications 1 à 5, comprenant en outre un amplificateur pour le signal représentatif du niveau de puissance de transmission en amont desdits atténuateurs multiples.

7. Circuit de commande de niveau de puissance pour un dispositif de communications comprenant :
un dispositif de communications ayant une commande de niveau de puissance transmis ;
un détecteur de puissance selon l'une quelconque des revendications 1 à 6 pour délivrer un signal de niveau de puissance représentatif du niveau de puissance de transmission dudit dispositif de communication.

8. Procédé pour commander le niveau de puissance de transmission d'un dispositif de communication comprenant les étapes de :
a. délivrer un signal de niveau de puissance représentatif du niveau de puissance du signal transmis par le dispositif de communication ;
b. atténuer le signal de niveau de puissance avec une cascade successive d'atténuateurs (30) pour ainsi délivrer une pluralité de signaux d'atténuateurs ;
c. détecter une caractéristique de chacun de la pluralité de signaux d'atténuateurs pour ainsi délivrer des signaux de détecteur multiples ;
d. amplifier chacun des signaux de détecteur ;
e. additionner les signaux de détecteur amplifiés pour délivrer un signal de commande ; et
f. commander le niveau de puissance de transmission du dispositif de communications en réponse au signal de commande.
